# EUROPEAN PATENT APPLICATION

(11) **EP 3 211 663 A1**
(43) Date of publication of application: **30.08.2017**
(21) Application number: 17158474.1
(22) Date of filing: 28.02.2017
(51) Int. Cl.: H01L 21/67, H01L 21/673, H01L 21/677

(54) **HORIZONTAL FURNACE SYSTEM AND METHOD FOR HANDLING WAFER BOATS, AND WAFER BOAT**

(30) Priority: 29.02.2016 NL 2016334
(71) Applicant: Tempress IP B.V., 8171 MD Vaassen (NL)
(72) Inventor: KOLK, Barteld, 7908 LC Hoogeveen (NL)
(74) Representative: Nollen, Maarten Dirk-Johan

(57) **Abstract**

The horizontal furnace system comprises a furnace station comprising a plurality of processing tubes arranged above each other and a load station for loading wafer boats into and unloading wafer boats from said processing tubes. Wafer boat loaders are configured for receiving wafer boats in a loading position and for transporting said wafer boats between the loading position and a processing tube. The load station comprises a loading space configured for loading and unloading wafer boats. The load station further comprises at least one conditioning chamber configured for conditioning a wafer boat subsequent to transportation of said wafer boat out of a processing tube, which chamber comprises a door giving access to the conditioning chamber from the loading space. Furthermore, heat removal means are present that are configured for removal of heat from the at least one conditioning chamber out of the load station.

## Description

### Field of the invention

The invention relates to a horizontal furnace system. The invention also relates to the use of such a system, for instance in a method for handling wafer boats and more particularly in a method of manufacturing a semiconductor device such as a solar cell. Further, the invention relates to a wafer boat for holding wafers.

### Background of the invention

For the production of semiconductor devices such as integrated circuits or photovoltaic cells (solar cells), wafers - i.e. semiconductor substrates) are subjected to a number of processing steps. These processing steps include processing in a high temperature furnace system. For example, the furnace system is used for diffusion, annealing, thermal oxidation or deposition such as chemical vapour deposition (CVD), such as atmospheric pressure CVD, vacuum CVD (also known as LPCVD) or plasma enhanced CVD (PECVD). The temperatures used are for instance in the range of 400°C to 1000°C or even higher.

The wafers are introduced in the processing tubes of the furnace system, also known as furnace chamber. To this end, the wafers are placed on a wafer boat. Such a wafer boat typically carries a plurality of wafers. In the solar cell industry, a wafer boat typically carries more than 100 wafers, for instance 250, 500 or 1000. Even larger wafer boats are foreseen in order to increase through-put and therewith reduce cost price of solar cells. For processes at atmospheric pressure the wafers are in general arranged parallel to each other on the wafer boat, with small intermediate distances, for example 2mm up to 12mm from each other. For example, the wafer boats for atmospheric pressure processes may be provided from quartz or silicon carbide. For example, for plasma enhanced CVD the wafer boats may be provided inter alia from thin graphite plates, graphite nuts, ceramic rods and spacers.

The wafer boat is transported into the processing tube by means of a wafer boat loader. For furnace systems having a horizontal processing tube, the wafer boats are transported substantially horizontally into and out from the processing tube, i.e. the movement direction from a loading position into the processing tube is primarily horizontal, which does not exclude that some variation in height may occur. Horizontal furnace systems are typically used for processing of photovoltaic cells, i.e. solar cells. The loading position is defined within a load station positioned adjacent a furnace station. Each wafer boat loader can load wafer boats from the loading position into an open end of a corresponding processing tube of the furnace station, and also vice versa. The open end of each processing tube may be closable by an automatic door, as is common in furnace systems.

A wafer boat loader for a horizontal furnace system typically includes a support onto which the wafer boats are to be positioned. Preferably, the support is a cantilevered support. For example, the cantilevered support may comprise a paddle or two support rods, the latter also known as "twin rods". The support with the wafer boat thereon will be moved so as to be inserted into the processing tube. The support is normally thereafter retracted from the processing tube. The tube may then be closed and the processing begun. After processing, the support would again be moved into the processing tube and be moved below or around the wafer boat for unloading the wafer boat.

Due to the need for a high throughput, particularly in the manufacture of solar cells, horizontal furnace systems typically include multiple processing tubes arranged vertically above one another. Currently, Applicant sells furnace systems with four or five processing tubes on top of each other. For each processing tube a wafer boat loader is provided for loading and unloading wafer boats from the processing tube. Such systems typically include a load station lift for transporting wafer boats to the wafer boat loaders of each processing tube. A single load station lift is usually sufficient for the vertical stack of wafer boat loaders.

As mentioned before, typical temperatures inside the processing tubes range from 400 °C up to 1000 °C or even higher. Since the wafers need to be unloaded from the load station at lower temperatures, or even at room temperature, a careful cooling down process is needed. If the wafers are exposed to low temperatures too quickly, this gives a temperature shock. Such shock likely has an effect on the device efficiency due to microcracks and other microstructural defects. However, a temperature shock may further give rise to yield loss due to cracks in the wafers or the like. That clearly has to be prevented as much as reasonably possible. Moreover, also the wafer boat and the cantilever of the wafer boat loader, e.g. the paddle or the twin rods, may suffer damage from said temperature shock, which is in particular disadvantageous as these cantilevers are expensive parts of the system.

In order to prevent and/or limit the damage, several measures are conventionally taken. First of all, the temperature of the processing tube is typically ramped down before a wafer boat leaves the furnace tube, particularly when the processing is carried out at high temperatures, i.e. at 800°C or higher. Furthermore, a cooling down period in the furnace tube may be foreseen, possibly after opening of the furnace door. Secondly, after unloading from the processing tube, the wafers in the wafer boat are further cooled down, before being unloaded from the wafer boat loader. Thirdly the unload speed may be lowered to reduce the temperature shock. The cooling down occurs primarily by leaving the wafer boat as is. All these measures have a negative impact on the cycle time of the process, thereby reducing the through-put of the system. Especially in solar cell manufacturing, the through-put is an essential specification of a furnace, because it strongly influences the cost structure of producing solar cells.

The heat transferred from the wafer boat(s), the processing tube and the supports of the wafer boat loaders into the load station is significant. Thereto, the load station is conventionally provided with means for introducing and removing a gas, e.g. air. The gas may flow upwards through the load station, after which it may be exhausted to the cleanroom. Unfortunately both ways of removing the hot air are rather expensive, since the heated air will be replaced by cleanroom air that is typically expensive to generate. The temperature in the load station is suitably monitored and the gas flow set so as to keep the temperature within a predefined range.

### Summary of the invention

It is therefore an object of the invention is to overcome or at least reduce the above problems and to provide an improved horizontal furnace system to increase the through-put of number of wafers per hour, reduce the energy consumption and to reduce the damage to wafers and wafer boats and corresponding yield loss.

According to an aspect of the present invention, a horizontal furnace system is provided, comprising a furnace station comprising a plurality of processing tubes arranged above each other and a load station for loading wafer boats into and unloading wafer boats from said processing tubes, which load station is provided with a loading means, such as a load station lift, and a plurality of wafer boat loaders that are arranged above one another substantially in alignment with the processing tubes, each of which wafer boat loaders is configured for receiving wafer boats in a loading position and for transporting said wafer boats between the loading position and a processing tube, and which loading means is arranged and configured to load wafer boats onto and unload wafer boats from the wafer boat loaders when positioned in their loading positions.

According to the invention, the load station comprises (1) a loading space configured for loading wafer boats onto said loading means and unloading them from said loading means, and (2) at least one conditioning chamber configured for conditioning a wafer boat subsequent to transportation of said wafer boat out of a processing tube, which chamber is accessible from the loading space, for example by means of a door provided in the conditioning chamber. The load station further comprises heat removal means configured for removal of heat from the at least one conditioning chamber out of the load station.

It was understood by the inventors, that these problems be solved by creating smaller compartments within the load station, allowing for better heat management. The smaller compartment is a conditioning chamber configured for conditioning a wafer boat subsequent to transportation of the boat out of the processing tube. The conditioning chamber is provided with heat removal means for removal of heat out of the load station.

The smaller size of the conditioning chamber enables better heat removal and generally better temperature control. Further, the cooling gas, such as air, from conditioning chamber will not be mixed with the air in the load station, which is found to be beneficial. First the load station will stay substantially cooler than in the known systems, in which wafer boats with wafers are cooled within the load station. Furthermore, the cooling gas, that is exhausted from the conditioning chamber will have a higher temperature, which allows more effective heat recovery by using for instance recirculation or heat exchangers on the air flow coming from the conditioning chamber. By means of creating of a substantially horizontal separation between the individual wafer loaders and a separate exhaust for the conditioning chamber, temperatures can be kept in each conditioning chamber within a desired range, even without excessive air flows.

Suitably, the conditioning chamber is configured such that a wafer boat can remain longer therein, without blocking the entrance of the adjacent processing tube for a further or second wafer boat. This allows a reduction of the cycle time of processing.

In one particular embodiment, a plurality of conditioning chambers is present, each configured for one or two wafer boat loaders, and suitably separated from each other by means of a suitable wall. Herewith, the heat flow towards wafer boat loaders arranged at a top level is decreased; due to the walls, the transfer of heat from a lower wafer boat loader upwards is blocked or at least decreased. Furthermore, because of the smaller size, the gas flow rate may be limited, and the orientation of the gas flow may be controlled more directly, i.e. the distance between gas inlets and the wafer boat is reduced, and there will be less intermediate elements that can change the flow path in an unforeseen manner. In one suitable implementation, each pair of neighbouring chambers comprises at least one heat shielding wall which extends in the horizontal plane and which is positioned between the two corresponding wafer boat loaders.

A further advantage of providing a plurality of conditioning chambers is that in case a wafer breaks and shatters, the pieces are collected at the bottom of the corresponding conditioning chamber, instead of spreading throughout the system.

In one implementation, the conditioning chamber is completely closed. In an alternative implementation, the chambers are substantially closed, wherein some openings may be present. In one suitable embodiment, the chamber is provided with at least one aperture allowing that a frame of the wafer boat loader, particularly comprising an elongated beam, remains outside the conditioning chamber, whereas a support of the wafer boat loader is inside the conditioning chamber. This is deemed beneficial for stability, but also to keep sensitive electronic components coupled to the guide or frame at a lower temperature. The walls of the chambers may for example comprise a metal or metal alloy, such as stainless steel or aluminium.

In a further implementation, the heat removal means is embodied in that the conditioning chamber is provided with an inlet for gas and at least one outlet for cooling gas. The cooling gas could be air, but also another gas, such as nitrogen. The air could be cleaned to meet cleanroom requirements, as known per se. The above mentioned aperture could for instance be used as the inlet. The outlet is suitably one or more exhaust ducts. More preferably, the inlet and the outlet are arranged such that a flow path between inlet and outlet runs substantially parallel to substrates (wafers) on a wafer boat arranged in the conditioning chamber, and more particularly in the cooling down position as will be discussed hereinafter in more detail. Preferably, this is arranged such that the gas may flow in between of the wafers, therewith enabling an effective and efficient way of cooling. Thus, particularly in this manner, the temperature of the wafers may be reduced with increased speed and reduced gas flow in comparison to the prior art.

In a further embodiment, the load station has a passive or active cooling system. A solution for active cooling may be the re-circulation of cooling gas, such as air, in the load station, which will further reduce the consumption of expensive cleanroom air. Such re-circulation may be arranged such that a heat-exchanger is placed with the furnace and its load station, whereby the heated air is actively cooled using water, which will be a much more effective cooling and thus less expensive way than exposing the heated air to the cleanroom. Such a solution further reduces temperature increase in the load station.

In a further embodiment hereof, the furnace including its load station will be equipped with one or more heat-exchangers to actively cool the furnace and its load station. For these heat exchangers in the conditioning chambers and in the furnace and its load station to perform properly it is required that the air is fully circulated through respectively the conditioning chamber and the furnace. For both conditioning chamber and furnace this requires that the cooled air will have to be inserted at the bottom of the furnace and its load station. Thereto, in this embodiment, channels are present to lead air from the furnace will be lead through channels from the top of the furnace to the bottom of the furnace. These channels can be dedicated piping in the different sections of the furnace. In one implementation, the channels are inserted in the door elements, which are placed on the outer casing of the furnace. For the conditioning chambers it is deemed beneficial to have separate channels per chamber. This will allow very effective heat-exchange per chamber.

In an embodiment, each conditioning chamber is arranged to enclose the open end of the corresponding processing tube of a horizontal furnace station adjacent the load station during use. By enclosing the open end, the heat radiated from said open end and gas leaving the tube will heat up the chamber. Therefore, an intermediate temperature between the chamber and the rest of the load station may be maintained without additional heating. Moreover, by enclosing said open ends, gas leaving the processing tube does not enter the load station directly, but is contained in the chambers. In one implementation, each chamber has a side wall opposing the corresponding processing tube, and an aperture is present below said side wall, configured such that a wafer boat loader loaded with wafers can extend under said side wall to the processing tube.

In another embodiment, the conditioning chamber is provided with support means for support of a first wafer boat in a cooling down position, wherein the cooling down position is arranged relative to a wafer boat loader such that a second wafer boat may be present on the support and be transported into the corresponding furnace tube, when the first wafer boat is in the cooling down position. Due to the creation of a cooling down position, the cooling down period in the conditioning chambers may be extended, and thus the required cooling rate be reduced. This allows that heat is removed less quickly, and/or that the temperature difference between the wafers in the wafer boat and the atmosphere in the conditioning chamber is reduced. Moreover, by moving a first wafer boat away from the wafer boat loader the load station lift and the wafer boat loader are made available to handle a second wafer boat while the first wafer boat cools down. Therefore, the total number of wafers that can be processed per unit time is increased.

According to an embodiment, a transporter is provided for each wafer boat loader, each transporter being arranged to move a wafer boat between a position on the support of the corresponding wafer boat loader in a transfer position and a cooling down position within the chamber outside the path travelled by the loading means when loading or unloading the wafer boat loader.

In other words, a transporter may move a wafer boat from the wafer boat loader to a 'parking position', i.e. the cooling down position. The 'parking position' is located outside the path of movement of the loading means, e.g. the load station lift. For example, when a load station lift is arranged to move towards the wafer boat loader from for example a front side, the 'parking position' may be located to the rear side of the wafer boat loader. The transporter is thereto suitably made of materials that can withstand the temperature of the wafer boat, at least in portions that will make contact with the wafer boat. The front side is herein the side through which a wafer boat may enter the loading space and/or the conditioning chamber.

In a further embodiment, each transporter comprises a rotatable shaft extending substantially parallel to the support, and a set of coupling arms mounted to and extending from the shaft, such that the first wafer boat is movable between the transfer position and the cooling down position by rotation of the rotatable shaft. This embodiment is gentle, as it allows to move the wafer boat by movement in a single direction, thus also a single operation. Furthermore, the rotatable shaft can be easily integrated into the wafer boat loader.

A further advantage of using a rotatable shaft is that it constitutes a mechanism for rotational movement that can be implemented in a heat resistant manner, and typically also economically feasible.

Particularly, in one implementation, the support is coupled with a carriage to an elongated beam and/or a guide coupled thereto, extending parallel to the rotatable shaft and to the support. The rotatable shaft may then be arranged between the elongated beam and the support, with the carriage extending suitably below the rotatable shaft. In this manner, the wafer boat can be rotated upwards without blocking the movement of the support in the movement direction defined by said beam and/or guide. Moreover, the wafer boat is brought to a position closer to the beam and/or guide, particularly when seen in a top view. This is deemed beneficial, as this is preferably at the rear side of the chamber. Therewith the size of the chamber may be kept small, and there is no mutual hindering of the cooling down position and the door. More particularly, there is sufficient room for loading any second wafer boat onto the wafer boat loader without getting too close to or in contact with the first wafer boat in the cooling down position. However, this does not exclude that the arrangement of the rotatable shaft may be different than this preferred position between the support and the beam and/or guide.

In a further embodiment, the set of coupling arms is provided with holding means suitable for holding the first wafer boat, which is preferably provided with holding elements cooperating with said holding means. The presence of such holding elements and holding means that fit to each other is deemed suitable for a safe gripping of the wafer boat, i.e. without risk of falling. Preferably, the holding elements of the wafer boat are arranged onto side panels thereof. In a preferred implementation, the cooperating holding means and holding elements are configured such as to rotate the wafer boat relative to the coupling arms during movement between the transfer position and the cooling down position, such that the wafer boat remains in a horizontal position. Thus under the effect of gravity, the bottom side of the wafer boat remains the bottom side, notwithstanding the rotation with the coupling arms extended from the rotatable shaft. Optionally, the transporter is provided with a first pulley or sprocket provided coaxially to the axis of the rotational shaft and in a fixed manner, such that the rotational shaft can rotate relative to the first pulley or sprocket. The first pulley or sprocket is connected via a belt or chain to a second pulley or sprocket which is provided to the holding means of the coupling arms of the transporter. The second pulley or sprocket is rotatable with respect to the coupling arms. Therefore, when the rotational shaft of the transporter rotates, said rotation with respect to the first pulley or sprocket will be transferred via the chain or belt to the holding means, thereby rotating the second pulley or sprocket and keeping the wafer boat upright.

In one implementation, the holding means comprises a tube provided around the shaft and moveable with respect to the shaft by means of the drive, the tube being provided with the laterally extending arm for coupling to a wafer boat. Suitably, in a further embodiment, the arm is provided with an opening or protrusion for cooperation with the holding element of the wafer boat, for instance in the form of a corresponding protrusion or opening respectively.

Preferably, a transfer of the wafer boat from the cooling down position to the load station lift is executed via the wafer boat loader, i.e. the wafer boat is transferred from the transporter onto the wafer boat loader and subsequently from the wafer boat loader to the loading means, or vice versa. In an alternative embodiment, the loading means and the transporter may be arranged to transfer a wafer boat directly from the transporter onto the loading means.

It is observed in this respect that for sake of clarity the position on the wafer boat loader to the cooling down position has been named transfer position, whereas the position on the wafer boat loader to the load station lift is the loading position. In one embodiment, the transfer position and the loading position are different positions, i.e. after return to the wafer boat loader, a wafer boat should be moved in the movement direction of the support. In another embodiment, the transfer position and the loading position are physically the same position on the wafer boat loader. It will be understood that the transfer position furthermore arranges the holding means of the rotatable shaft around the wafer boat, wherein the loading position is suitable for arranging any holding means of the load station lift to the wafer boat. The positions of these different holding means are suitably arranged under control of a system controller.

Suitably, the wafer boat loader comprises moving means for moving the support, the support being configured for insertion into the processing tube. The support comprises or consists of a material that is stable up to a predefined operation temperature of the processing tube, or at least stable to remain in the processing tube of such period during the limited period needed for placement of the wafer boat therein, and for taking up the wafer boat for unloading of the processing tube.

In a particularly preferred embodiment, the moving means comprise at least one motor coupled to the - elongated, linear - guide and/or said carriage as discussed above. The conditioning means are arranged and configured such that the elongated guide and/or the carriage with the said at least one motor is present substantially outside the conditioning chamber. This is deemed advantageous, because the motors are components that are typically vulnerable for high temperatures. It has to be taken into account that the motors are more particularly electromotors and that their operation is sensitive so as to position the wafer boat loader correctly into the processing tube without damage to a wafer boat on top of the wafer boat loader or in the processing tube. So, vibrations and or operation tolerance due to variations in temperature will be improved in this embodiment, also in the course of time. In addition, the lifetime of the motor is increased, reducing down time of the system.

Suitably, the support is in this respect a cantilevered support and the guide is provided with means for variation of the vertical position and thus compensate for bending through of the support under the load of the wafer boat. More particularly, the elongated guide is tiltable about a horizontal rotation axis, and the carriage of the wafer boat loader is coupled to said guide and configured to move along said guide when driven. The cantilevered support herein suitably extends parallel to the guide. For example, the guide may comprise a guide rail or guiding shaft, along which the carriage may travel. For example, the guide may be connected to a joint, e.g. comprising a hinge or a shaft, for effecting the tilting around the horizontal axis.

A displacement drive is connected to the carriage and configured for moving the carriage along the guide. A lifting drive is connected to the guide and configured for tilting the guide by lifting a distal end thereof relative to a proximal end thereof. In accordance with this embodiment, the displacement drive and/or the lifting drive of each wafer boat loader are arranged outside the corresponding chamber.

In one further embodiment, in order for the wafer boat loader to be able to automatically load and unload the wafer boats from the cantilevered support the carriage includes a mechanism for vertical displacement of the paddle. Vertical displacement of the wafer boat allows vertically landing the boat from the cantilevered paddle onto the bottom wall of the processing tube. Sliding contact of the boat with the walls of the processing tube is thereby avoided, to minimize generation of contaminating particles and to avoid breakage of the boat and wafers or damage to the processing tube. This type of wafer boat loader is therefore also called a soft landing wafer boat loader.

For example, the system includes a wafer boat loader assembly as described in Dutch patent application NL2014606, filed 9 April 2015, entitled "Wafer boat loader assembly, furnace system, use thereof and method for operating said assembly", which is hereby incorporated by reference. As described in the referenced application, the use of such a construction is particularly advantageous when a large number of wafers may be loaded on a single wafer boat, e.g. 500-1000 wafers or possibly even more, as used and/or desired in the production of solar cells.

Moreover, as the lifting drive is not travelling with the carriage, the lifting drive experiences less heat from the processing chamber. Therefore, failure of the lifting drive or associated electronic components is prevented. Furthermore, the lifting drive may be more effectively shielded from the heat of the furnace chamber.

Preferably, the assembly only comprises the displacement drive and the lifting drive for effecting horizontal and vertical movement, i.e. no further drives are provided. In particular, the assembly preferably includes no more than two motors.

Preferably, the horizontal rotation axis has a fixed position. In other words, the assembly is preferably configured to only allow rotation of the guide, whereas translational movement is prevented. In such an embodiment, the guide has only a single degree of freedom, namely tilting, i.e. pivoting, about the horizontal rotation axis. Preferably, the horizontal rotation axis is provided at the proximal end of the guide.

The invention further relates to the use of the horizontal furnace system of the invention for carrying out at least one processing step on a batch of wafer present in a wafer boat. As will be understood for the above, such use is advantageous so as to provide yield loss, in combination with the ability to use wafer boats configured for a large number of wafers, i.e. 500, 1000 or potentially more. Furthermore, the efficiency of processing is further improved by means of the higher loading time of a processing tube of a furnace system (less time needed for logistics) and the ability to use a furnace system with many processing tubes on top of each other, i.e. 4, preferably 5 or more.

More specifically, according to one embodiment, the use comprises the steps of: (1) loading a first wafer boat to a loading position on a wafer boat loader using the loading means, such as a load station lift, which loading step comprises introducing the wafer boat into a conditioning chamber, e.g. through a door thereof; (2) transporting the first wafer boat from the loading position into a processing tube; (3) carrying out at least one processing step in the processing tube; (4) transporting the first wafer boat out of the processing tube; (5) removing heat from the conditioning chamber out of the load station; and (6) unloading the first wafer boat out of the conditioning chamber of the loading station.

In the present advantageous embodiment, the wafer boat enters the conditioning chamber already before entry of the processing tube. More specifically, the loading position on the wafer boat loader is arranged within the conditioning chamber.

Optionally, the temperature and any other conditions (humidity, content of the atmosphere, such as oxygen content) in the conditioning chamber into which the wafer boat is loaded are controlled in accordance with predetermined settings. For example, the settings are controlled such that the temperature and other conditions will be within an acceptable range, for instance not exceeding a predefined limit. Also, during cooling down, the conditions in the conditioning chamber are controlled in the course of removing heat. Particularly, the heat removing rate is controlled, typically under the control of a system controller on the basis of stored information (i.e. on the number of wafers, the type of wafer boat, the process step that has been carried out), but suitably also or alternatively on the basis of sensing input, i.e. from sensors located in the conditioning chamber and/or at further relevant locations.

In one further embodiment, the first wafer boat is transported out of the processing tube into a transfer position, and is then transferred to a cooling down position in the conditioning chamber. This embodiment allows an increased efficiency of the use of the furnace system, and/or more gradual cooling down. Implementations of the furnace system thereto, have been discussed hereinabove and apply also to the present use. Particularly, the unloading of the first wafer boat out of the conditioning chamber occurs via the loading position. In one further implementation, the transfer position and the loading position are physically the same position.

The use of the furnace system is particularly intended as part of a method of manufacturing a semiconductor device, preferably a solar cell, while a semiconductor substrate of the semiconductor device is present in or on a wafer boat.

In one further aspect, the invention relates to a method for handling wafer boats in a horizontal furnace system comprising a load station and an adjacent furnace station. The invention further relates to a method for processing wafers in a horizontal furnace system.

In an embodiment, the method comprises:
a) positioning a wafer boat loader in a loading position, wherein a support of the wafer boat loader extends at least partially within a conditioning chamber of the load station;
b) if a door is present, opening a door of the conditioning chamber;
c) using a loading means, such as a load station lift or a robot, to load a first wafer boat onto the support of the wafer boat loader in the conditioning chamber;
d) if a door is present, closing the door of the chamber;
e) inserting the first wafer boat into a processing tube of the furnace station using the wafer boat loader;
f) processing the first wafer boat in the processing tube; and
g) carrying the first wafer boat out of the processing tube into the chamber using the wafer boat loader.

The same advantages and effects as described above with respect to the horizontal load station apply to the method according to the invention.

In a further embodiment, the method further comprises, after step g):
h) transporting the first wafer boat from a position on support of the wafer boat loader to a cooling down position within the chamber using a transporter; and
while the first wafer boat remains in the cooling down position:
i) if a door is present, opening the door of the chamber;
j) using the loading means to load a second wafer boat onto the support of the wafer boat loader;
k) if a door is present, closing the door of the chamber; and
l) inserting the second wafer boat into the processing tube of the furnace station using the wafer boat loader,
and while the second wafer boat is in the processing tube:
m) transporting the first wafer boat from the cooling down position to the support of the wafer boat loader using the transporter;
n) if a door is present, opening the door of the chamber;
o) removing the first wafer boat from the chamber using the loading means; and
p) if a door is present, closing the door of the chamber.

Preferably, a door of a first conditioning chamber is only opened, when the door of any second conditioning chamber within the load station is closed, to reduce the heat load on the load station lift. In other words, the method preferably comprises opening only one door of the chambers at a time. Instead of a door, a window may be present so as that the conditioning chamber is accessible from the loading space. Mixing of air between the loading space and the conditioning chamber may then be limited. Such limitation can for instance be achieved by means of a proper design of the conditioning chamber with respect to the size of the window. Moreover, the location of inlet and outlet of cooling gas and the window may be chosen, so as to create a preferable flow path for the cooling gas through the conditioning chamber, such that a separation zone is created between the window and the flow path. Furthermore, the window could be used as inlet for cooling gas.

Preferably, the method comprises maintaining in the conditioning chamber a temperature higher than in the rest of the load station compartment. The temperature in the conditioning chamber is suitably controlled by a controller and need not to be fixed in time. Furthermore, in order to prevent temperature shocks to the second wafer boat that is entered into the conditioning chamber while the first wafer boat is cooled down, the temperature in the conditioning chamber may be monitored, and arrangements made in relation thereto. For instance, the controller may be configured, in one implementation, to allow entrance of the second wafer boat only upon sensing that the temperature in the conditioning chamber has reached a predefined upper limit.

The invention further relates to a wafer boat for holding wafer, comprising two side panels connected by a wafer supporting structure, the side panels comprising:
- at least one support foot for supporting the wafer boat, e.g. on a support of a wafer boat loader;
- protruding elements protruding substantially perpendicular to the side panels for engagement with holding means of a load station lift; and
- a holding element for cooperation with holding means present on an arm extending from a rotatable shaft, which holding element is configured such that upon rotation of the rotatable shaft and the arm thereto, the wafer boat moves upwards while being supported by the arms and while rotating relative to said arm under the effect of gravity.
This wafer boat is particularly configured for transport for the transfer position to the cooling down position and back, and more particularly such that under the rotating movement to the cooling down position, the bottom side of the wafer boat nevertheless remains in a horizontal arrangement, so that the wafers cannot fall out.

The same advantages and effects as described above with respect to the horizontal furnace system apply to the wafer boat according to the invention.

In an embodiment, the holding elements comprise an arc-shaped protrusion forming a downward facing receptacle for receiving a protrusion of a further wafer boat transporter. This is deemed an advantageous implementation to achieve the desired counter-rotation of the wafer boat under upwards rotation with arms extending from a rotatable shaft.

The invention also relates to an alternative horizontal furnace system, and its use, said system comprising a furnace station comprising a plurality of processing tubes arranged above each other and a load station for loading wafer boats into and unloading wafer boats from said processing tubes, which load station is provided with a plurality of wafer boat loaders that are arranged above one another substantially in alignment with the processing tubes, each of which wafer boat loaders is configured for receiving wafer boats in a loading position and for transporting said wafer boats between the loading position and a processing tube, wherein the system is further provided with support means for support of a first wafer boat in a cooling down position, wherein the cooling down position is arranged relative to a wafer boat loader such that a second wafer boat may be present on the support and be transported into the corresponding furnace tube, when the first wafer boat is in the cooling down position.

In one embodiment of the alternative horizontal furnace system, a transporter is present for movement of the first wafer boat between a transfer position on the support and the cooling down position. Preferably, each transporter comprises a rotatable shaft extending substantially parallel to said support, and a set of coupling arms mounted to and extending away from the shaft, such that the first wafer boat is movable between the transfer position and the cooling down position by rotation of the rotatable shaft. Further preferably, the set of coupling arms is provided with holding means suitable for holding the first wafer boat, which is preferably provided with holding elements cooperating with said holding means. Even further preferably, the cooperating holding means and holding elements are configured such as to rotate the wafer boat relative to the coupling arms during movement between the transfer position and the cooling down position, such that the wafer boat remains in a horizontal position.

This alternative horizontal furnace system has the benefits of enabling more efficient cooling and logistics. It is most beneficially applied in combination with the conditioning chamber(s) as discussed before, but that is not deemed strictly necessary. The specific embodiment of transferring the wafer boat by means of a rotatable shaft has anyhow the advantage that merely one additional motor is needed (rather than two for a conventional translation). Moreover, said motor can be placed at sufficient distance from the wafer boat that needs to cool down, due to the arrangement with a rotatable shaft. The sufficient distance allows that the heat up of the motor is significantly limited. If desired, an insulating package or box may be applied around the motor, so as to further reduce the inflow of heat.

The same advantages and effects as described above with respect to the embodiments comprising a conditioning chamber and heat removal means apply to the alternative horizontal furnace system. Moreover, the features described above with respect to embodiments comprising a conditioning chamber and heat removal means, may optionally be combined with the alternative horizontal furnace system.

Again a further alternative furnace system is provided comprising a furnace station comprising a plurality of processing tubes arranged above each other and a load station for loading wafer boats into and unloading wafer boats from said processing tubes, which load station is provided with a plurality of wafer boat loaders that are arranged above one another substantially in alignment with the processing tubes, each of which wafer boat loaders is configured for receiving wafer boats in a loading position and for transporting said wafer boats between the loading position and a processing tube, wherein the system is further provided with circulation means for circulation of cooling gas through the furnace system, and with a heat exchanger configured for cooling of cooling gas that has passed the load station and/or the processing tube. In this furnace system, the cooling gas is not removed into the environment, but the furnace system comprises a substantially closed system for cooling gas, including channels for transporting the cooling gas from a top side to a bottom side of the system. More precisely, the channels are envisaged to run entirely from the top side to the bottom side, and the cooling gas such as air is pumped through the channels by means of a fan or other gas pumping means. The heat exchanger herein has an inlet coupled to an exhaust of the loading station, such as of a conditioning chamber or processing tube, and an outlet coupled to the fan. Suitably the furnace system may be operated in a recirculation mode and a fresh air mode. In the latter, cooling gas is not recirculated but removed from the furnace system via a system outlet, while fresh air from the environment is introduced via a system inlet. The operation may shift from the recirculation mode to the fresh air mode and vice versa under the control of a controller or by means of an automatic protection circuit that moves to the fresh air mode based upon a sensor input, for instance a temperature sensor.

The above described horizontal load station, horizontal furnace system, method and wafer boat may for example be used for the production of semiconductor devices, in particular solar cells. However, the processing of micro-electromechanical systems (MEMS) or any other semiconductor or thin film device such as bulk acoustic wave filters, is not excluded. In particular, the invention is suitable for handling wafer boats carrying a relatively large load, e.g. a wafer boat carrying 500 or more wafers per wafer boat, in particular for processing of solar cells.

### Brief introduction to the figures

These and other aspects of the invention will be further elucidated with reference to the figures, in which:
- Figure 1 shows in a schematic, isometric view the furnace system according to an embodiment of the present invention; wherein the doors of the conditioning chambers are all closed;
- Figure 2 shows in a schematic, isometric view a horizontal furnace system corresponding to Figure 1, but with some of the doors opened;
- Fig. 3A shows in isometric view a part of the load station of the furnace system of the invention, wherein side walls facing away from the processing tube have been left out for clarity.
- Figure 3B shows a front view of the horizontal furnace system of figure 2;
- Figure 3C shows a cross section of the horizontal furnace system according to line C-C in figure 3B;
- Figure 4 shows in isometric view a wafer boat according to an embodiment of the invention;
- Figure 5A shows in isometric front view a wafer boat loader of the load station of figures 1-3 carrying the wafer boat of figure 4, and a corresponding transporter, wherein the transporter is in a first state for picking up the wafer boat from the wafer boat loader;
- Figure 5B shows in detail the part indicated "5B" in figure 5A, to further illustrate the first coupling arm of the transporter;
- Figure 5C shows the second coupling arm of the transporter in a front view;
- Figure 5D shows the second coupling arm of the transport in a back view;
- Figure 6 shows in isometric view the front of the wafer boat loader and transporter of figures 5A-D, wherein the wafer boat has been transferred to the transporter and the transporter has moved the wafer boat to its cooling down position;
- Figure 7 show in isometric view the wafer boat loader of figures 6, wherein a second wafer boat has been loaded onto the cantilevered support, while the first wafer boat remains on the transporter;
- Figure 8A shows a schematic diagram illustrating a conventional method for processing wafer boats;
- Figure 8B shows a schematic diagram illustrating a method for loading and unloading,
- Figure 9A shows a schematic diagram illustrating flow of cooling gas for cooling the at least one conditioning chamber, according to a first embodiment;
- Figure 9B shows a further schematic diagram illustrating flow of cooling gas through the conditioning chambers and the loading space of the load station, according to a second embodiment.

### Detailed description of illustrated embodiments

The figures are not drawn to scale and merely diagrammatical in nature. Equal reference numerals in different figures refer to identical or corresponding features.

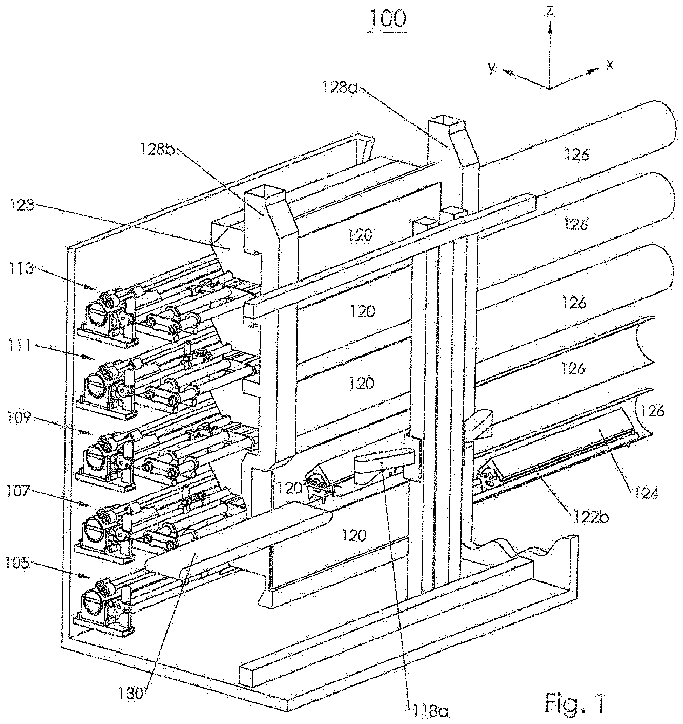

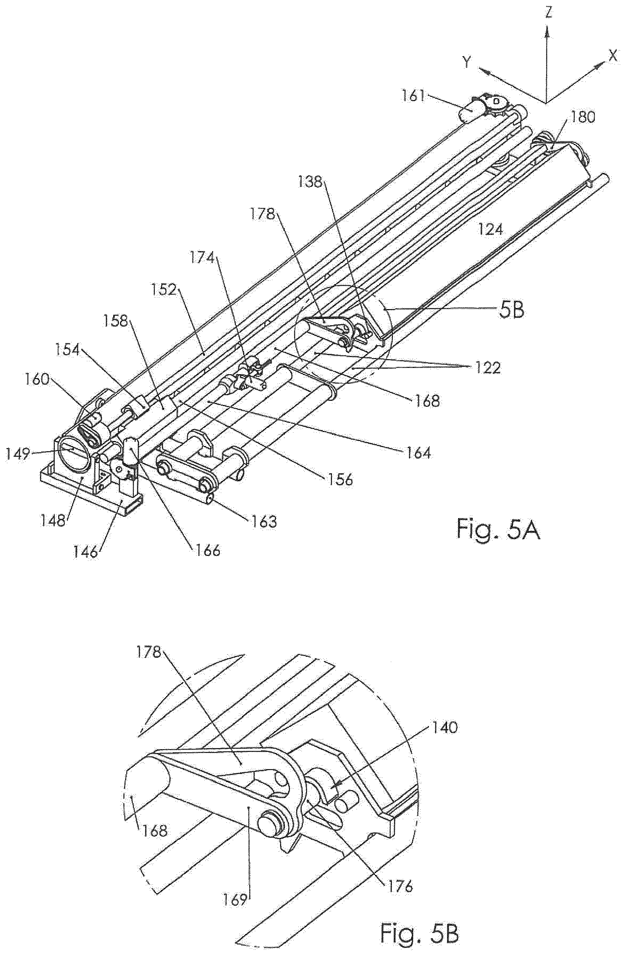

Figure 1 shows in a diagrammatical view a furnace system according to one embodiment of the invention. It is observed that any electrical elements, such as a controller and sensors, as well as a user interface have been left out for clarity. Furthermore, the processing tube is shown merely schematically, without any details with respect to its inside. The furnace system is provided with a plurality of processing tubes 126, five in total. The processing tubes 126 are of the horizontal type as known per se. Each processing tube 126 is provided with a wafer boat loader 105, 107, 109, 111, 113. A wafer boat loader 105, 107, 109, 111, 113 comprises in general a frame, here an elongated guide 150 and a support 122. The support 122 is movably connected to the frame 150 by means of a carriage. The construction of a wafer boat loader 105 will be discussed in more detail with reference to Figure 5A. The wafer boat loaders 105, 107, 109, 111, 113 are generally arranged such that with a movement in a first, primarily or substantially horizontal direction a wafer boat may be transported from a loading position into the processing tube 126. This movement typically also involves a vertical component, so as to ensure that the support 122 of the wafer boat loader does not bend downwards under the load of a wafer boat with wafers, particularly in case of 500 or more wafers, and at the increased temperatures present in the furnace system. Therefore, the support is suitably a cantilevered support.

According to the invention, the load station 100 of the furnace system is provided with a plurality of conditioning chambers 104, 106, 108, 110, 112 within a housing 102 of a load station 100, that are arranged above each other within housing 102. In other words, the chambers 104, 106, 108, 110, 112 define sub-compartments of the housing 102 of the load station 100. In this preferred embodiment, there is one conditioning chamber for each wafer boat loader 105 and each processing tube 126. However, it is not excluded that the one or more conditioning chambers 104-112 are merged into one. This may be particularly feasible for the conditioning chambers 104-112 that are arranged in the lower part of the load station. Since heat does flow upwards, it is foreseen that heat problems are bigger in the upper part. However, it is deemed particularly beneficial to have one conditioning chamber for each wafer boat loader, since this also allows individual control of the conditions in the conditioning chamber. Given that the loading of the chambers is typically and suitably not simultaneous, it is beneficial that the temperatures can vary. However, alternatively, the chambers could be held at a constant temperature in case of steady operation.

In the shown embodiment, the conditioning chambers 104-112 are arranged such that the frame 150 of the corresponding wafer boat loader 105-113, which is in the form of an elongated guide, remains outside the conditioning chambers 104-112. Furthermore, the carriage and a portion of the support 122 are left outside the conditioning chambers 104-122. This is deemed beneficial so as to shield sensitive electric components from the heat in the conditioning chambers 104-122. Such sensitive components include for instance electric motors that are located on the frame 150 (especially the beam thereof) or on the carriage.

The exemplary system shown in Figure 1 contains five levels, i.e. five chambers 104, 106, 108, 110, 112 with corresponding wafer boat loaders 105, 107, 109, 111, 113 arranged above one another to cooperate with five processing tubes 126. However, the invention is not limited to five levels, and any suitable number of levels may be used. For example, the load station 100 may be provided with 5-10 levels.

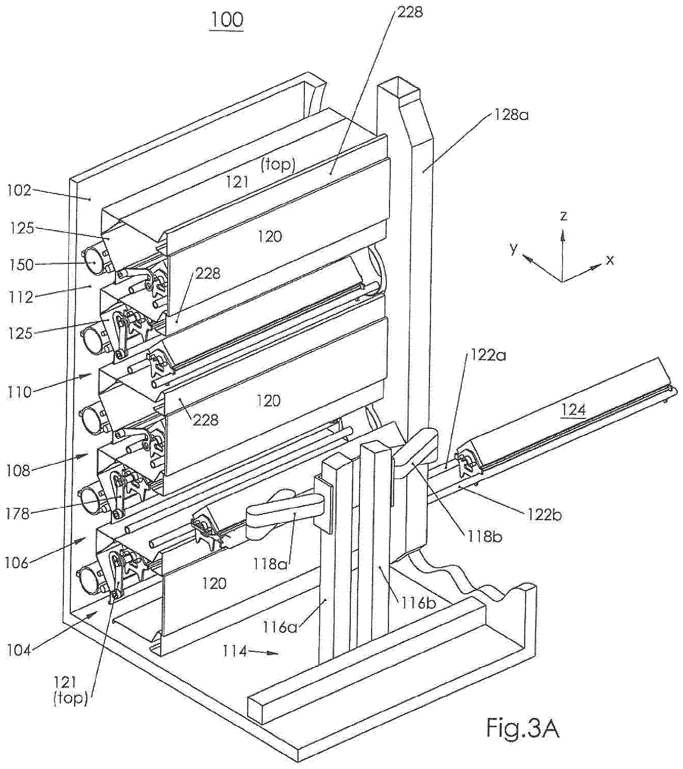

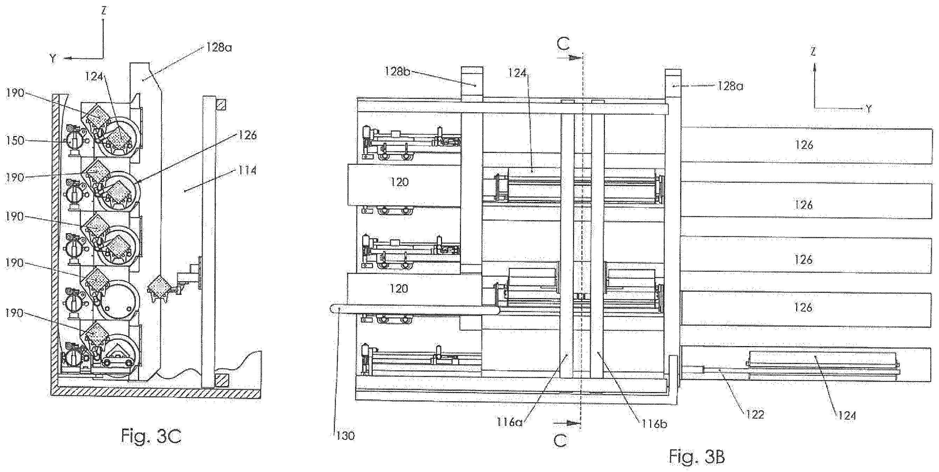

The furnace system as shown in Fig. 1 further comprises a load station lift 114 and means 128 for heat removal from the conditioning chambers. Though not shown, there is preferably also a means for heat removal from a loading space of the load station, i.e. the space outside the conditioning chambers 104-112. The load station lift 114 shown in the example comprises two uprights 116a, 116b and two arms 118a, 118b which can move in the vertical direction along the uprights, i.e. the z-direction (see also Figure 3). Moreover, the arms 118a, 118b are extendable in the y-direction, i.e. movable in the horizontal direction to the chambers and vice versa.

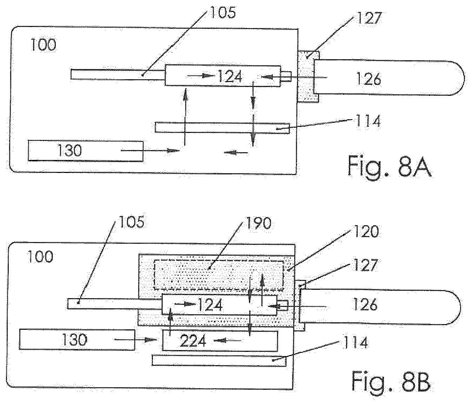

The operation of the invention according to one preferred embodiment will now be elucidated in comparison to the prior art. Figure 8A shows schematically a plan view of a conventional horizontal furnace system. Figure 8B shows schematically a plan view of a furnace system according to one embodiment of the invention. As shown in Figure 8A, the load station 100 of said conventional horizontal furnace system comprises a number of wafer boat loaders arranged above each other. Figure 8A shows only one wafer boat loader 105 of said stack of wafer boat loaders. Load station 100 further comprises a load station lift 114. The load station 100 is adjacent to a furnace station. The furnace station comprises a processing tube 126 for each wafer boat loader. Figure 8A shows a first wafer boat 124 loaded onto the wafer boat loader. When the first wafer boat 124 has been processed in processing tube 126, it is brought back into load station 100. As the first wafer boat 124 is too hot for further handling, the first wafer boat 124 is parked on the wafer boat loader 105 for a while to cool down, before being transferred to the load station lift 114 for further handling of the wafer boat 124. This implies that the heat is to be removed from the load station 114. Typically, this is carried out by the provision of a flow of cooling gas. Particularly in a system with a four or more of processing tubes on top of each other, for instance 5 or 6 or more, the heat tends to accumulate close to the upper wafer boat loader in the system. This makes it difficult to maintain desired temperatures. When cooling gas is used, the flow rate needs to be so high, that wafers may be pushed out of the wafer boat, or pushed against each other, or be slightly shifted within the wafer boat leading to instability during later movements of the wafer boat. This is undesired and has a risk of yield loss. Also, if the temperature in the loading station at a specific wafer boat loader cannot be controlled within suitable ranges, this may lead to temperature shocks to the wafers, leading to yield loss and/or to reduction in life time.

Figure 8B shows schematically a plan view of a horizontal furnace system according to an embodiment of the invention. The load station comprises a number of wafer boat loaders arranged above each other. Figure 8B shows only one wafer boat loader 105 of said stack of wafer boat loaders. Load station 100 further comprises a load station lift 114 and a conditioning chamber 120. Chamber 120 is positioned adjacent to the processing tube 126 associated with the wafer boat loader 105, to enclose the open end of said tube 126. By retaining part of the heat irradiated by the wafer boats after processing and the heat coming from the tube 126 when the tube 126 is opened to load or unload wafer boats, the chamber 120 obtains an intermediate temperature between the temperature in the processing tube 126 and the temperature in the rest of the load station 100. Therefore, the temperature gradient experienced by the wafer boats 124, 224 leaving the processing tube is reduced, and cracks or damage to the boats and the wafers is avoided or at least reduced.

Moreover, the load station 100 of figure 8B is provided with a transporter to move the wafer boats 124, 224 between a position on the wafer boat loader 105 and a cooling down position 190, also referred to as "parking position" 190. Therefore, a first wafer boat 124 may be parked in said cooling down position 190 after processing in tube 126 such that its temperature can cool down from the temperature in tube 126 to the temperature of the chamber 120 without occupying the wafer boat loader 105. The "parking position" 190 is located outside the travel path of the load station lift 114, such that a second wafer boat 224 may be loaded onto the wafer boat loader 105 for processing in tube 126 while the first wafer boat 124 cools down.

Figures 8A-B also show a scavenger 127 which may optionally be present at the open end of the processing tube 126. In some embodiment of the inventions the scavenger 127 may optionally be connected to the same exhaust system as ducts 128a, 128b, or a separate system may be provided.

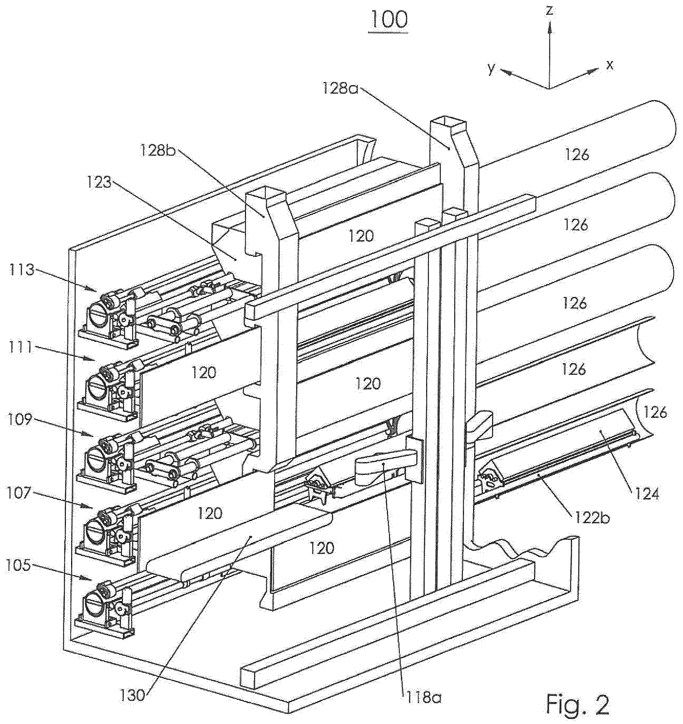

Figure 2 shows in a diagrammatical view the furnace system as shown in Figure 1, wherein some of the doors are opened, and wafer boats 124 are shown. Each chamber 104, 106, 108, 110, 112 is provided with a door 120, in the example shown the door 120 is slidable in the x-direction, i.e. in the horizontal direction corresponding to the direction of movement of the carriage of the wafer boat loader.

The chambers 104, 106, 108, 110, 112 each comprise side walls, a top wall 121 and a side wall 123 facing away from the processing tube 126. Although not visible, preferably, the chambers 104-112 do not have a side wall facing towards the processing tube 126 or merely have a partial side wall, that allows a wafer boat to pass to the processing tube. For sake of clarity, a processing tube is provided with a door. Therefore, an additional door is deemed not necessary. However, if desired, it is not excluded that the conditioning chamber 104-112 is also provided with a door in the side wall facing towards the processing tube 126. In the example shown, the top wall 121 of a first chamber constitutes the bottom wall of any chamber 106-112 directly overlying said first chamber. As shown in figure 2, the support 122 of a wafer boat loader 105 can extend underneath the side wall 123. The twin rods 122a, 122b extend within the chamber 104, 106, 108, 110, 112 such that a wafer boat 124 can be supported by the twin rods 122a, 122b within the corresponding chamber 104, 106, 108, 110, 112. Because of the smaller size of the conditioning chamber, there are more walls and corners in which gas may be removed, or introduced into the chamber.

The load station 100 further comprises a conveyor belt 130 for transport of the wafer boat to a station for loading and unloading the wafers into wafer boats. Load station lift 114 is arranged to pick up wafer boats 124 to be processed supplied by the conveyor belt 130 and to load them onto the twin rods 122a, 122b of a selected wafer boat loader 105, 107, 109, 111, 113. Moreover, after processing of the wafer boat 124, the load station lift 114 can place the wafer boat 124 onto the conveyor belt 130 which transport the processed wafer boat to an automated wafer boat unloading station (not shown).

The chambers 104, 106, 108, 110, 112 are in the illustrated embodiment each connected to an exhaust system via two exhaust ducts 128a, 128b at the two opposing ends of the chambers. The exhaust system is arranged to remove gasses from the chambers. Although the chambers 104, 106, 108, 110, 112 are open at the bottom parts of their side walls, the suction of the exhaust system prevents gasses from exiting the chamber via the open bottom. As hot air rises, a relatively low exhaust flow is needed to prevent gasses from escaping the chambers.

In the present embodiment, the heat removal means comprise means for flowing a cooling gas into at least one conditioning chamber and out of the conditioning chamber via one or more outlets in each chamber and an exhaust system coupled to said outlets. This embodiment of heat removal means is appropriate in view of high temperatures of the wafer boat and any substrates (wafers) loaded thereon, after removal from the furnace . The chamber is suitably provided with one or more inlets. It turns out that one or more apertures between the walls of the conditioning chamber are suitably used as inlets. However, inlets from a specific gas source could be used alternatively. Normally, due to a natural tendency of warm air to rise up and any pressure profile being generated as a result of the change in temperature, there is a flow of cooling gas through the chamber by itself.

Preferably, these means for gas flow are adjustable per conditioning chamber, suitably under control of a system controller with the help of one or more sensors. This adjustable gas flow setting enables to adjust the temperature dependent on the presence of a wafer boat in a conditioning chamber. Typically, the unloading of wafer boats from processing tubes in one system will not occur simultaneously, at least not completely simultaneously and not for all processing tubes. As a consequence, the heat removal is not needed for all conditioning chambers simultaneously, at least not to the same extent.

In the shown embodiment, each chamber is connected to an exhaust system via multiple outlets which are distributed over the chamber in the horizontal direction and/or via at least an elongated outlet extending in the horizontal direction. In the shown embodiment, an elongated exhaust outlet system 228 is present between said exhaust ducts 128a, 128b. In this manner, heat can be removed from a conditioning chamber 104-112 more efficiently, i.e. by means distributed along the elongated side of the conditioning chambers 104-112. This is deemed particularly suitable, as the gas may be directed in this manner in a direction substantially parallel to the wafers present in the wafer boat 124. This distribution of the cooling gas in a direction parallel to the orientation of the wafers in the wafer boat enables that the cooling gas easily penetrates into the spaces between adjacent wafers. Therefore, the cooling efficiency is increased.

The chambers 104, 106, 108, 110, 112 in the example shown are not completely closed. For example, wall 125 opposite door 120 may be provided with an opening (as will be discussed below) or the bottom side of the chamber may be open. Such openings in the chamber may function as an air inlet for supplying relatively cool air from the load station into the chambers. In a currently preferred embodiment, air is supplied into the chamber from the side of the chamber opposite door 120, to obtain an air flow substantially parallel to the plane of the wafers towards the outlet 228.

It is noted that the air expelled from the chambers by the exhaust system has a higher temperature than the air expelled from a load station in conventional furnace systems. As the temperature difference AT between the hot air and the heat exchange medium is therefore increased, the exhaust air may be more efficiently cooled in the system according to the invention.

Optionally, the one or more exhaust ducts may be provided with one or more valves controlled by a temperature control unit to maintain the temperature within the chamber below a predefined upper temperature and/or above a predefined lower temperature. By opening the valve, hot air can be removed from the chamber via the exhaust duct. The temperature control unit controls the valve to open when the temperature within the chamber exceeds a predetermined threshold, thereby cooling the chamber to maintain the temperature below the predefined upper temperature. For example, the predefined temperature and the predetermined threshold may be set to 100-200 degrees Celsius. By maintaining a sufficiently low temperature in the chamber, it is ensured that the wafers can cool down after being processed in the processing tube. Likewise, the temperature control unit may be arranged to close the valve when the temperature within the chamber is below a predetermined lower threshold. For example, the lower threshold may be set to 50 - 70 degrees Celsius. By maintaining a sufficiently high temperature in the chamber, it is ensured that the wafers experience a smaller temperature shock than in conventional systems.

In other words, the temperature control unit is preferably arranged to control the valve to maintain within the chamber an intermediate temperature between the temperature in the processing tube and the temperature within the rest of the load station.

Optionally, a heat exchanger is connected to the exhaust system. The hot air removed from the conditioning chambers may be actively cooled by the heat exchanger. It is noted that the temperature in the chamber and the rest of the load station will in general not be constant over time and may also vary with spatial location. According to the invention, the average temperature within the chamber is higher than the average temperature within the rest of the load station.

In a furnace system using filtered air, i.e. air having a low concentration of particles, the cooled off air may be reintroduced into the system. In such a system, the need for filtration is reduced. However, if desired the cooled off air may be fed through a filter before recirculating the air in the system.

Figure 3A shows a portion of Fig. 2. For sake of clarity, the load station lift 114 has not been shown. Furthermore, the side walls 123 of the conditioning chambers 104-112 have been left out, so as to provide a view on the configuration of the conditioning chambers 104-112. Figure 3B shows a front view and Fig 3C shows a cross-sectional view along the lines C-C in Fig. 3B. These figures indicate clearly the arrangement of the various elements of the system of the invention.

This Figure 3A illustrates effectively the location of a wall 125 between the frame or elongated guide 150 and the cooling down position within the conditioning chambers 104-112. This wall 125 is suitably a heat-shielding wall. It may be made of a thermally insulating material as known per se.

Optionally heat removal means may be present in or on the wall 125, for instance in the form of heat pipes. Alternatively or in addition, the heat shielding wall 125 may contain a first layer of thermally insulating material, and a second layer of heat conducting material, through which heat may be directed to a heat sink at a location further away from the frame 150, for instance close to a heat exchanger. The first layer and the second layer do not need to be laminated. In one embodiment, they may be spaced apart. A fluid medium between said walls can further assist in the heat management. The fluid medium is for instance a gas or fluid that is driven around by means of a pump. Furthermore, the heat shielding wall may contain a surface that reflects rather than absorbs heat radiation. Therewith, it is made that a major portion of the heat remains in the atmosphere that is then cooled by means of the flow of a cooling gas.

Fig. 3A furthermore shows the various possible positions of a wafer boat in the conditioning chambers, i.e. the loading position, the transfer position, the cooling down position and the extended position in which a wafer boat is (or moves towards or from) the processing tube.

In the first conditioning chamber 104, the support 122 of the wafer boat loader 105 has been moved to the processing tube (not shown for sake of clarity). The support 122 holds a wafer boat 124, and is ready for placement of the wafer boat 124 into the processing tube or for removal of the wafer boat 124 from the processing tube. Furthermore, a second wafer boat is present in the first conditioning chamber 104, and more particularly in the cooling down position.

The second conditioning chamber 106 is opened for loading of a wafer boat onto the support, in this embodiment implemented as a so-called twin rod. A second wafer boat is present in this second conditioning chamber in the cooling down position. The second wafer boat is held in this cooling down position by means of a plurality of arms extending from a rotatable shaft and coupled to the wafer boat with holding means. It is visible that the arm is oriented upwards in the cooling down position. This upwards position is deemed most preferable, though another configuration is not excluded. For instance, the rotation towards the cooling down position could be over an angle of more or less than 75 degrees, suitably more than 75 degrees. Optionally, further means may be available for stabilizing the wafer boat in this cooling down position. Such additional stabilization means are however not preferred.

A single wafer boat is present in the third conditioning chamber 108 in the transfer position. It is visible that an arm is coupled to one side panel of the wafer boat. The arm extends upwards at an angle to the horizontal plane of approximately 15 degrees. An angle slightly larger than 0 degrees, for instance 5-25 degrees is deemed constructionally beneficial, though not essential. The arm will in the movement to the cooling down position be rotated towards the - preferred - vertical position, in this example thus over 75 degrees.

A first and a second wafer boat are present in the fourth conditioning chamber 110. In this chamber, the first wafer boat is in the loading position and the second wafer boat is in the cooling down position.

Finally, the upper conditioning chamber 112 comprises a single wafer boat in the transfer position. It will be understood that the shown locations of the wafer boats in the conditioning chambers are purely illustrative and indicate one possible loading configuration on one single moment during processing. It is further observed that in this illustrated example all the conditioning chambers comprise a separate cooling down position, facilitated by a mechanism with arms and a rotatable shaft. However, this is not deemed essential. It could be that merely some of the chambers is provided with a cooling down position

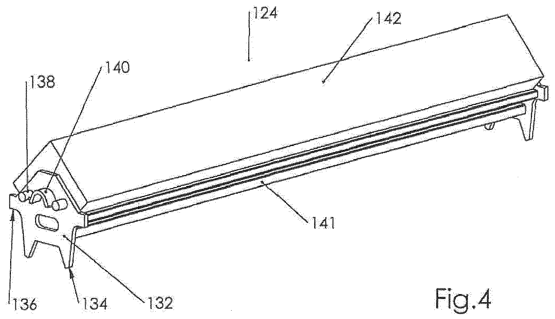

Fig. 4 shows in diagrammatical view a first embodiment of a wafer boat 124 suitable for use in the furnace system of the invention. The wafer boat 124 comprise two end faces or side panels 132 (figure 4). The side panels 132 each comprise support feet 134 for supporting the wafer boats 124 in a processing tube 126. In addition, the side panel 132 comprises at least one support face that is being supported by the support 122 of the wafer boat loader 105 when the wafer boat 124 is on the support 122. This at least one support face is in the present embodiment embodied as a plurality of - more specifically two in this example - protrusions 136 extending in the plane of the panels 132 at both sides of each panel 132, and forming a downward facing support surface for carrying the wafer boat 124 with twin rods 122a, 122b. The side panels 132 of the wafer boat 124 protruding elements for engagement with holding means of the load station lift 114. These protruding elements are embodied as two longitudinally extending protrusions 138 for picking up the wafer boat 124 with the load station lift 114. The side panels further comprise a central supporting protrusion 140 for picking up the wafer boat 124 by the transporter, as will be explained below. Between the front panel 132 and the back panel 132 of the wafer boat 124 is provided a supporting structure 141 for supporting wafers 142. In the drawings the wafers 142 are schematically drawn as a rectangular block, however in practice of course the wafers 142 are thin plates which are stacked in the supporting structure 141. For example, up to 1000 wafers may be provided in the wafer boat 124.

Fig. 5A-7 illustrates the construction of a wafer boat loader 105 and a transporter according to an embodiment of the invention. The wafer boat loader corresponds largely to the wafer boat loader described in Dutch patent application NL2014606, filed 9 April 2015, entitled "Wafer boat loader assembly, furnace system, use thereof and method for operating said assembly", which is hereby incorporated by reference. Said prior application does however not show a transporter as in embodiments of the present invention. Furthermore, the present example comprises twin rods as cantilevered support, whereas the prior application describes a paddle as cantilevered support. According to the present invention a paddle may however be used instead of twin rods.

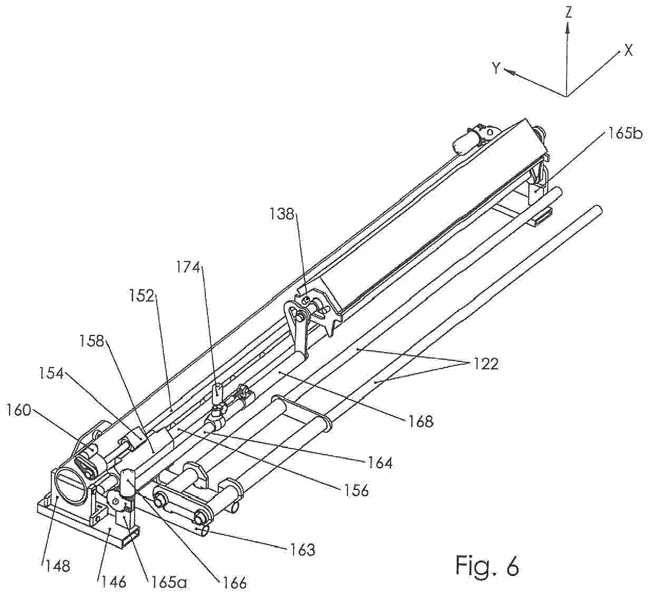

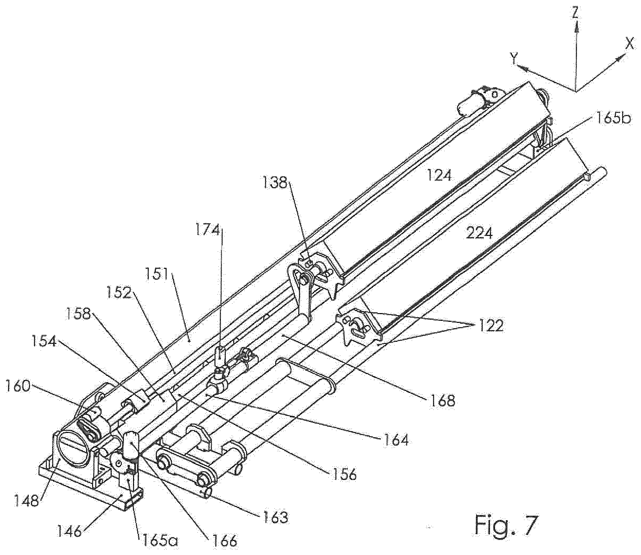

Fig. 5A herein shows the wafer boat loader 105 with a first wafer boat 124 present in the transfer position. Fig. 6 shows the same wafer boat loader 105, after transfer of the first wafer boat 124 to the cooling down position. Fig. 7 shows the same wafer boat loader 105, after loading a second or further wafer boat 224 into the loading position on the support 122 of the wafer boat loader 105.

Referring first to figure 5A, the wafer boat loader 105 comprises a frame 150 to which a support 122 is movably connected by means of a carriage 163. Several motors 159, 160, 161, 166 are connected to the frame 150. It is observed that reference numeral 150 is not indicated in this Fig. 5A, for the avoidance of confusion. In the shown embodiment, the frame 150 comprises a base 146 that supports an elongated beam 151 via a loader pivot 148. This beam 150 is pivotally connected to the loader pivot 148. In the example shown, beam 151 is provided in the form of a tube, which has the advantage of being a light structure having a high strength. A proximal end of beam 151 is connected to loader pivot 148 via a rotation shaft 149, allowing the opposing distal end of beam 151 to be displaced vertically by rotation of beam 151 about shaft 149. This upwards movement of the distal end of the beam or guide 151 is important so as to enable that the support with a wafer boat 124 is correctly moved towards a processing tube, without ending up in a downward orientation under the weight of the wafer boat 124. Furthermore, such vertical movement also allows arranging the support 122 below a wafer boat 124 when the wafer boat is in the processing tube and has to be taken up out of the processing tube.

Mounted to the tube 151 is a linear guide bar and a linear drive shaft 152. A linear drive nut 154 is provided on the linear drive shaft 152 for displacement of the nut 154 along the drive shaft 152. A guide shaft 156 is mounted to beam 151. Linear drive nut 154 is connected to a guide block 158 suspended on the guide shaft 156, and is thus moveable along the guide shaft 156 and the linear drive shaft 152. The block 158 is further suspended on guide bar 151 mounted to beam 151 via a guiding roller 159 disposed on an opposing side of the beam 151 with respect to the guide shaft 156, thereby preventing rotation of block 158 about the guiding shaft 156 due to the weight of the wafer boat when in a loaded state. The linear drive nut 154 is connected to elements extending substantially parallel to the guide shaft 154, to which the support 122 is connected. The ensemble of the guide block 158, drive nut 154 and these elements constitutes the carriage 163. In this embodiment, the elements are a twin rod support. Suitably, the twin rod support comprises means for adjusting the alignment of the twin rods.

The linear drive shaft 152 is rotated using electromotor 160. In the example shown, shaft 152, linear drive nut 154 and electromotor 160 are part of the displacement drive of the wafer boat loader 105 (and this part of the moving means). However, according to the invention the displacement drive may be embodied differently.

In the example shown, linear drive nut 154 is a rolling ring drive. The use of a linear drive nut 154 enables a smooth horizontal displacement of the carriage. Although the use of a linear drive nut is advantageous, alternatively other linear drives may be provided for horizontal displacement of the carriage.

The free distal end of beam 151 comprises a lifting drive 161 for displacing the distal end vertically by means of spindle 162. As support 146, 148 has a fixed position, beam 151 has a single degree of freedom, in the form of rotation. Alternatively, the wafer boat loader 105 may comprise a drive for translational movement of the proximal end of beam 151, in particular vertical movement. For example, instead of only providing lifting drive 161 at the distal end of the beam 151, a further drive may be provided at the proximal end of beam 151.

The twin rods 122 can be displaced vertically by tilting beam 151 using lifting drive 161. The twin rods 122 are positioned at a distance from the carriage by means of laterally extending frame of the carriage 163. The construction of the illustrated embodiment has the advantage that the lifting drive 161 and displacement drive 160 can be positioned outside the conditioning chamber, as illustrated in figures 3A-C. More particularly, the side wall 125 of the conditioning chamber 105 is configured such that the carriage 163 (and particularly the laterally extending support element thereof) can move between the side wall 125 and a top wall 121 of an underlying chamber. For example, an opening may be present in side wall 125 for extending the laterally extending support of the carriage 163 through said opening. In another example, the side wall 125 may be provided at a distance from a bottom wall, such that a gap is present between the bottom wall and the side wall 125 for passage of the laterally extending support of the carriage 163. Such an opening or gap may function both as passage for the carriage 163 and as air inlet for supplying relatively cool air from the load station into the conditioning chambers.

Although the examples show a wafer boat loader 105 which is tiltable by tilting beam 151 using drive 161, the wafer boat loader 105 may alternatively be of a type wherein a drive for vertical displacement of the cantilevered support is included in the carriage.

A transporter is further mounted to the base 146. The transporter comprises a turning shaft 164 and a swivel motor 166 for rotation of the turning shaft 164. The transporter is suspended in bearing uprights 165a, 165b (see figure 6). A set of coupling arms 178, 180 is coupled to the shaft 164 and extend therefrom. The coupling arms are provided with holding means 176 suitable for holding the wafer boat 124, and more particularly holding elements 140 thereof.

The operation of the transporter is discussed in more detail with reference to Fig. 5A and the detail shown in Fig. 5B. In the illustrated embodiment, the transporter is provided with means for moving the arms 178, 180 and the holding means 176 thereon towards and away from a wafer boat 124. Thereto, a bush 168 is provided on the turning shaft 164 of the transporter. The bush 168 is movable back and forth over the shaft by means of a spindle motor drive 174, which is again suitably kept outside the conditioning chamber 104-112.

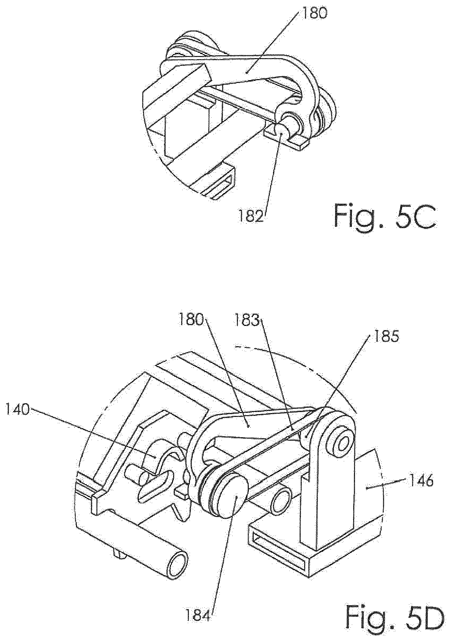

In the shown embodiment, the holding means 176 are embodied as a cylindrical protruding part 176. The arm 178 is in this embodiment strengthened by a further laterally extending part 169. The free outer end of arm 178 has the shape of a hook. Said free outer end of arm 178 is further provided with an opening, for movement of cylindrical part 176 through said opening. When bush 168 is moved in longitudinal direction by drive 174, cylindrical part 176 is moved together with bush 168 to engage or disengage the arc-shaped protrusion 140 of wafer boat 124. The same construction may be used at the other arm 180. In a currently preferred embodiment, the other arm 180 is provided with a rotatable element 182 (figure 5C). Said element 182 is in use inserted in arc-shaped protrusion 140 for picking up the wafer boat (figure 5D). The rotatable element 182 is fixedly connected to a pulley or sprocket 184, such that the rotatable element 182 and the pulley or sprocket 184 rotate together. Said first pulley or sprocket 184 is connected to a second pulley or sprocket 185 via a belt or chain 183. The second pulley or sprocket 185 is mounted in a fixed manner to support 146, such that when the rotatable shaft 149 is rotated, it also rotates with respect to said second pulley or sprocket 185. Said rotation will be transferred via the belt or chain 185 to the first pulley or sprocket 184, thereby also rotating rotatable element 182. In effect, the rotatable element 182 is rotated in a direction countering the rotation of shaft 149, thereby keeping the wafer boat upright.

Figure 6 shows the wafer boat loader and transporter of figures 5A-D in a state wherein the transporter has transported the wafer boat 124 to the cooling down position, by rotation of the turning shaft 164 using drive 174. Figure 7 shows the same configuration as in figure 6, wherein a second wafer boat has been loaded onto the twin rods 122a, 122b by means of load station lift 114.

It is observed that in this embodiment the turning shaft 164 is fixed to the base. While the beam 151 can be moved upwards, the turning shaft remains fixed. However, this does not hinder the vertical movement of the distal end of the beam 151. Such vertical movement occurs when the coupling arms 178, 180 are oriented upwards, either while carrying a wafer boat or while being empty. The bearing 165b is of a sufficient size so as to allow the distal end of the beam 151 to move up. Any wafer boat 224 thereon will not be hindered, since the distal end of the beam 151 is moved upwards, because the support tends to move downwards under the weight of such second wafer boat 224. Moreover, the upwards movement likely occurs particularly when the support is moved towards a processing tube and the second wafer boat 224 gets beyond the first wafer boat 124 present in cooling down position.

The method of an embodiment of the invention will be illustrated in further detail with reference to figures 1-7. In a first step of handling wafer boats 124, a door 120 of one chamber 106 of the load station 100 is opened, as shown in figure 1. Preferably, only one door 120 is opened at a time, i.e. the other doors 120 are closed while one of the doors 120 is open. In another example, a limited number of doors 120 are allowed to be open at the same time, e.g. two doors may be opened at the same time. After the door 120 of a chamber 106 has been opened, the load station lift 114 moves a wafer boat 124 into the chamber 106. The wafer boat has preferably already been picked up by the load station lift 114 from belt conveyor 130 (figure 2). The lift 114 carries the wafer boat 124 at the longitudinally extending protrusions 138 (figure 4). The lift 114 positions the wafer boat above the twin rods 122 of the wafer boat loader 107 in chamber 106. The wafer boat loader 107 has already been brought into the loading position. Subsequently, the lift 114 is moved down and the twin rods 122 are moved up by lifting drive 161. The lift 114 and twin rods 122 may be moved simultaneously or consecutively. By the vertical movement of the lift 114 relative to the twin rods 122 the twin rods 122 take over the wafer boat 124 from the lift 114. The wafer boat 124 is now supported by the wafer boat loader 107 at the laterally extending protrusions 136 of the wafer boat 124 (figure 4). The load station lift 114 then moves out of the chamber 106 and the door 120 of the chamber 106 is closed. The inlet end of the processing tube 126 is closable by a door (not shown in drawings). The door of processing tube 126 is opened, and the wafer boat 124 is carried into the processing tube 126 by the wafer boat loader 107. Said movement is brought about by displacement drive 160. The wafer boat loader 107 moves down by operation of the lifting drive 161 and positions the wafer boat 124 on its feet 134 on the bottom of the tube 126. The wafer boat loader 107 then moves out of the processing tube 126 by operation of displacement drive 160. The door of processing tube 126 is subsequently closed.

When the first wafer boat 124 has been loaded into the processing tube 126 as described above, the processing of the wafers is started. For example, the processing tube 126 is used for diffusion, annealing, thermal oxidation or chemical vapour deposition (CVD), such as atmospheric pressure CVD, vacuum CVD or plasma enhanced CVD. Before processing the temperature in the tube 126 may be ramped up, and likewise after processing the temperature in tube 126 may be ramped down.

After processing has completed, and optionally a temperature ramp down has been performed, the door of the processing tube 126 is opened. The wafer boat loader 107 is advanced towards the processing tube 126 and the twin rods are positioned underneath the wafer boat 124 in the processing tube 126. Subsequently the twin rods 122 are moved upwards by operating lifting drive 161 and the twin rods 122 engage with the laterally extending supports 136 of the wafer boat 124. The wafer boat loader 107 then moves back to the chamber 106 in the load station 100. The door of the processing tube 126 is closed after the wafer boat loader 107 has moved out of the tube 126. The arms 178 and 180 of the transporter are then moved down by rotation of turning shaft 164 by drive 166. The arms 178, 180 are then positioned at either side of the wafer boat 124, as illustrated in figure 5A. The wafer boat loader 107 may then be moved slightly in the direction towards processing tube 126 in order for arm 180 to engage the distal end of the wafer boat 124. The bush 168 is then moved relative to the turning shaft 164 by means of spindle motor 174. Therefore, cylindrical protrusion 176 moves trough the opening in the free end of arm 170 and is inserted in the down facing opening formed by the arc-shaped protrusion 140 of the wafer boat 124. To complete the transfer of the wafer boat 124 to transporter, the twin rods 122 may be moved downwards by operating lifting drive 161. The wafer boat 124 is then moved upwards and laterally towards the cooling down position by the transporter by rotation of turning shaft 164 by means of swivel motor 166, as illustrated in figure 6. The wafer boat may remain on the transporter in the cooling down position while another wafer boat is loaded onto the wafer boat loader 107 for processing in the tube 126, as illustrated in figure 7A.

After cooling down a wafer boat 124 in the upper position of the transporter, the wafer boat 124 is transferred out of the chamber 106 to the lift 114. First, the transporter is moved back in its lower position as illustrated in figure 6 by rotation of shaft 164 by motor 166. This positions the wafer boat 124 above the twin rods 122 of the wafer boat loader 107. The twin rods 122 are then moved upwards by operating lifting drive 161 to support the wafer boat 124 at laterally extending protrusions 136. The pick up device of the transporter is opened by moving bush 168 in the direction away from the furnace tube 126 by operation of spindle motor 174, thereby disengaging the cylindrical protrusion 176 of the pick up device from the arc-shaped protrusion 140 of the wafer boat 124. The wafer boat loader 107 may be moved in the direction away from the furnace tube 126 to disengage the rotatable element 182 from the distal end of the wafer boat 124. The empty transporter is then moved back to its upper position, by rotating shaft 164 by operating drive 166. The slidable door 120 of chamber 106 is opened and the load station lift 114 is moved towards the wafer boat 124, wherein the supporting arms of the lift 114 are positioned underneath the longitudinally extending protrusions 138 of the wafer boat 124. The twin rods 122 are then moved down by operating lifting drive 161 such that the wafer boat 124 is transferred to the load station lift 114. The lift 114 moves the wafer boat 124 out of the chamber 106 and the door 120 of chamber 106 is closed. The lift 114 may transfer the processed wafer boat 124 to conveyor belt 130 for further handling, e.g. for unloading wafers from said wafer boat 124.

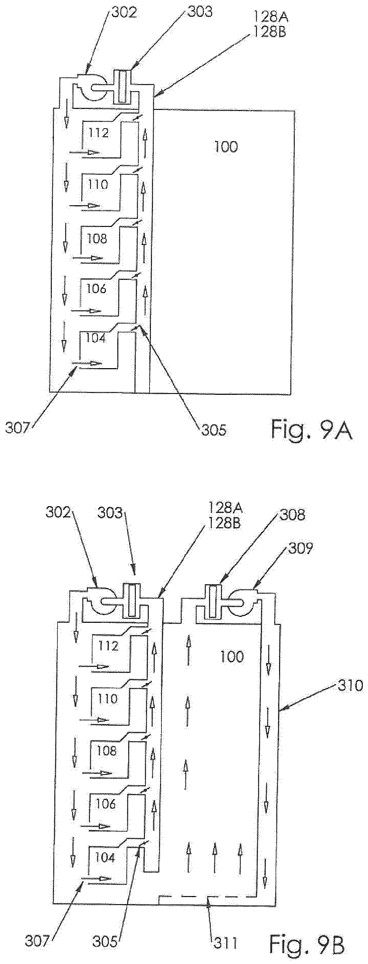

Figure 9A and 9B schematically show a further aspect of the invention, comprising conditioning chambers 104-112 and circulation means 302 for circulation of cooling gas. A first embodiment is shown in Fig. 9A, and a second embodiment is shown in Fig. 9B, which differs from the first embodiment in that the cooling gas is used as well for cooling of the loading space, and/or any of the processing tubes. The circulation means 302 are in the illustrated embodiment configured as a fan 302. Furthermore, the load station is configured for the generation of a flow path, that runs downwards from the fan 302, and then via the conditioning chambers 104-112 upwards through an exhaust duct 128. The downwards portion of the flow path may be configured as a pipe or channel with several outlets. Alternatively, this downward portion is arranged within the load station, for instance at a rear side thereof. In this alternative configuration, the downward portion is in open communication with the loading space. However, it is preferable that the outflow into the loading space is physically limited, for instance by the presence of the conditioning chambers 104-112.

Preferably, the flow rate per conditioning chamber 104-112 decreases from top to bottom (thus from 112, to 104). This is deemed beneficial, since it counteracts the tendency that the higher arranged conditioning chambers 108, 110, 112 heat up more. In one further implementation, shown in Fig. 9a, the flow path is configured so as to set a predefined distribution of cooling gas per conditioning chamber. A regulator 305 is present at an outlet of at least some and preferably each conditioning chamber 104-112. The regulators 305 in the conditioning chambers allow to specify the flow rate out of the conditioning chambers, and therewith the distribution. The total flow rate is preferably arranged by means of speed control of the fan 302. In another implementation, the system may be provided with distribution means, so as that the distribution of cooling gas can be tuned in dependence of a temperature and/or temperature increase in a conditioning chamber, as for instance identified by one or more temperature sensors.

As shown in Fig. 9a, the heated up cooling gas, typically air, is led from the exhaust duct 128 into a heat exchanger 303, such as an air-water heat exchanger. Rather than a single air duct 128, a double air duct 128A, 128B is provided in the preferred embodiment. The double air duct 128A, 128B may be lead either to a single heat exchanger 303, and a single fan 302, but alternatively to a set of two heat exchangers and fans, each corresponding for a single duct 128A, 128B. In case two fans are present, with corresponding downward channels, each of the channels may be configured to distribute the air accordingly. For instance the first channel distributes the cooled air to the bottom four conditioning chambers 104-110, whereas the other channel distributes the cooled air to the upper two or three conditioning chambers 108, 110, 112.

Fig. 9B shows a further and preferred embodiment, wherein indeed a first and a second fan 302, 309 are present, with heat exchangers 303, 308 arranged upstream of each fan 302, 309. The second recirculation means 309 further comprises an air duct 310 to transport the cooled air to the bottom of the load station 100, and via a distribution means 311 at the bottom side into the loading space of the load station 100. This is envisaged for further cooling of sensitive electronic components such as motors that are arranged in the loading space. Suitably, the downward channel is configured by means of its dimensions for laminar flow of cooling gas (air). This is deemed beneficial so as to reduce noise. In this embodiment, not merely the flow through the conditioning chambers 104-112 but also through the loading space is configured as part of a circular flow of cooling gas, such as air, which significantly reduces the consumption of cooling gas. The flow through the loading space and the conditioning chambers is herein suitably controlled and configured independently, so as that the basic temperature (after passing the heat exchanger) of the circulating flow through the loading space can be lower than that through the conditioning chambers. However, it is not excluded that both circular flows would be mixed, at least partially.

One advantage of the system with air recirculation means is that the flow rate needed for scavenging gases from the furnace can be reduced substantially.

The present invention is by no means limited to the above described preferred embodiments thereof. The rights sought are defined by the claims, within the scope of which many modifications can be envisaged.
The invention further relates to following aspects.
According to a first aspect, a horizontal furnace system is provided, comprising a furnace station comprising a plurality of processing tubes arranged above each other and a load station for loading wafer boats into and unloading wafer boats from said processing tubes, which load station is provided with a loading means and a plurality of wafer boat loaders that are arranged above one another substantially in alignment with the processing tubes, each of which wafer boat loaders is configured for receiving wafer boats in a loading position and for transporting said wafer boats between the loading position and a processing tube, and which loading means is arranged and configured to load wafer boats onto and unload wafer boats from the wafer boat loaders when positioned in their loading positions. The load station comprises a loading space configured for loading wafer boats onto the loading means and unloading wafer boats from the loading means. The load station further comprises at least one conditioning chamber configured for conditioning a wafer boat subsequent to transportation of said wafer boat out of a processing tube, which chamber is accessible from the loading space; and heat removal means configured for removal of heat from the at least one conditioning chamber out of the load station.

According to a preferred first embodiment of the first aspect, the at least one conditioning chamber is configured to contain part of the wafer boat loader and including the loading position, and wherein the loading means are configured for loading a wafer boat to the loading position in the at least one conditioning chamber, and for unloading a wafer boat from the loading position into the loading space. In one implementation thereof, the at least one conditioning chamber is configured so that a further part of the wafer boat loader is outside the conditioning chamber and preferably within the loading space, said further part comprises at least one moving means for driving and/or moving the wafer boat loader or portions thereof.

According to a second embodiment that may be combined with the first embodiment, each wafer boat loader comprises a support for carrying a wafer boat and moving means for moving of the support which support is configured for insertion into the processing tube, and the at least one conditioning chamber is configured such that the support of the wafer boat loader is present, at least a portion of the support configured for carrying the wafer boat, within the conditioning chamber.

According to a third embodiment that may be combined with any of the preceding embodiments, the conditioning chamber is provided with support means for support of a first wafer boat in a cooling down position, wherein the cooling down position is arranged relative to a wafer boat loader such that a second wafer boat may be present on the support and be transported into the corresponding furnace tube, when the first wafer boat is in the cooling down position. Preferably, a transporter is present for movement of the first wafer boat between a transfer position on the support and the cooling down position. More preferably, each transporter comprises a rotatable shaft extending substantially parallel to said support, and a set of coupling arms mounted to and extending away from the shaft, such that the first wafer boat is movable between the transfer position and the cooling down position by rotation of the rotatable shaft. Herein, the set of coupling arms may be provided with holding means suitable for holding the first wafer boat, which is preferably provided with holding elements cooperating with said holding means. Furthermore, the cooperating holding means and holding elements are configured such as to rotate the wafer boat relative to the coupling arms during movement between the transfer position and the cooling down position, such that the wafer boat remains in a horizontal position. In one implementation, the wafer boat loader comprises a beam extending substantially in a movement direction from the loader position to the furnace tube, and a carriage for connecting the support to the beam in a manner to be movable along said movement direction, wherein said rotatable shaft is present, when seen in top view, between the beam and the support. More particularly, the moving means comprise at least one motor coupled to said beam and/or other parts of the frame, and wherein the conditioning chamber is arranged and configured such that the beam and/or other parts of the frame with the said at least one motor is present substantially outside the conditioning chamber. In further embodiments of this aspect of the invention, which may be combined with any of the preceding aspects:
- the load station comprises one conditioning chamber per wafer boat loader; and/or
- the conditioning chamber is provided with at least one heat shielding wall: and/or
- the at least one chamber is arranged to enclose the opening of a corresponding processing tube; and/or
- a door is present between the loading space and the conditioning chamber, through which door a wafer boat can be loaded to and unloaded from the loading position, by means of the loading means, for instance a lift, and/or
- the heat removal means comprise means for flowing a cooling gas into at least one conditioning chamber, one or more outlets in each chamber and an exhaust system coupled to said outlets, and wherein the outlets are preferably distributed over the chamber in the horizontal direction and/or via at least an elongated outlet extending in the horizontal direction; and/or
- the support of each wafer boat loader is a cantilevered support, and wherein the elongated guide is tiltable about a horizontal rotation axis, wherein more preferably the elongated guide is tiltable by means of a lifting drive is connected to the guide and configured for tilting the guide by lifting a distal end thereof relative to a proximal end thereof, and/or
- the processing tube is configured for carrying out at least one process step in a semiconductor device manufacturing chosen from chemical vapour deposition, plasma enhanced chemical vapour deposition, thermal oxidation, atomic layer deposition, annealing, plasma etching, and/or
- circulation means are present for circulating cooling gas, which circulation means are configured to transport cooling gas from a top side of the system to a bottom side of the system, which cooling gas is used as heat removal means, and wherein a heat exchanger is present, particularly at a top side, for cooling of heated cooling gas that has passed the at least conditioning chamber, wherein preferably the heat exchanger is coupled to an exhaust of the conditioning chamber for collecting the heated cooling gas, and means are present for transporting the cooling gas from the heat exchanger to the conditioning chamber.

## Claims

1. Horizontal furnace system, comprising a furnace station comprising a plurality of processing tubes arranged above each other and a load station for loading wafer boats into and unloading wafer boats from said processing tubes, which load station is provided with a loading means and a plurality of wafer boat loaders that are arranged above one another substantially in alignment with the processing tubes, each of which wafer boat loaders is configured for receiving wafer boats in a loading position and for transporting said wafer boats between the loading position and a processing tube, and which loading means is arranged and configured to load wafer boats onto and unload wafer boats from the wafer boat loaders when positioned in their loading positions, **characterized in that** the load station comprises
- a loading space configured for loading wafer boats onto the loading means and unloading wafer boats from the loading means;
- at least one conditioning chamber configured for conditioning a wafer boat subsequent to transportation of said wafer boat out of a processing tube, which chamber is accessible from the loading space; and
- heat removal means configured for removal of heat from the at least one conditioning chamber out of the load station.

2. The horizontal furnace system as claimed in Claim 1, wherein the at least one conditioning chamber is configured to contain part of the wafer boat loader and including the loading position, and wherein the loading means are configured for loading a wafer boat to the loading position in the at least one conditioning chamber, and for unloading a wafer boat from the loading position into the loading space.

3. The horizontal furnace system as claimed in Claim 2, wherein the at least one conditioning chamber is configured so that a further part of the wafer boat loader is outside the conditioning chamber and preferably within the loading space, said further part comprises at least one moving means for driving and/or moving the wafer boat loader or portions thereof.

4. The horizontal furnace system as claimed in Claim 1-3, wherein
- each wafer boat loader comprises a support for carrying a wafer boat and moving means for moving of the support which support is configured for insertion into the processing tube, and
- the at least one conditioning chamber is configured such that the support of the wafer boat loader is present, at least a portion of the support configured for carrying the wafer boat, within the conditioning chamber.

5. The horizontal furnace system as claimed in Claim 1-4, wherein the conditioning chamber is provided with support means for support of a first wafer boat in a cooling down position, wherein the cooling down position is arranged relative to a wafer boat loader such that a second wafer boat may be present on the support and be transported into the corresponding furnace tube, when the first wafer boat is in the cooling down position.

6. Horizontal furnace system according to claim 5, wherein a transporter is present for movement of the first wafer boat between a transfer position on the support and the cooling down position, wherein preferably each transporter comprises a rotatable shaft extending substantially parallel to said support, and a set of coupling arms mounted to and extending away from the shaft, such that the first wafer boat is movable between the transfer position and the cooling down position by rotation of the rotatable shaft.

7. Horizontal furnace system according to claim 6, wherein the set of coupling arms is provided with holding means suitable for holding the first wafer boat, which is preferably provided with holding elements cooperating with said holding means, wherein preferably the cooperating holding means and holding elements are configured such as to rotate the wafer boat relative to the coupling arms during movement between the transfer position and the cooling down position, such that the wafer boat remains in a horizontal position.

8. Horizontal furnace system as claimed in any of the preceding claims, wherein the conditioning chamber is provided with at least one heat shielding wall.

9. Horizontal furnace system according to any preceding claim, wherein the heat removal means comprise means for flowing a cooling gas into at least one conditioning chamber, one or more outlets in each chamber and an exhaust system coupled to said outlets, wherein preferably the outlets are distributed over the chamber in the horizontal direction and/or via at least an elongated outlet extending in the horizontal direction.

10. Horizontal furnace system as claimed in any of the preceding claims, wherein circulation means are present for circulating cooling gas, which circulation means are configured to transport cooling gas from a top side of the system to a bottom side of the system, which cooling gas is used as heat removal means, and wherein a heat exchanger is present, particularly at a top side, for cooling of heated cooling gas that has passed the at least conditioning chamber, wherein the heat exchanger is preferably coupled to an exhaust of the conditioning chamber for collecting the heated cooling gas, and means are present for transporting the cooling gas from the heat exchanger to the conditioning chamber.

11. Use of the horizontal furnace system as claimed in any of the preceding claim in the manufacture of semiconductor device, particularly a solar cell.

12. The use as claimed in claim 11, wherein said use comprises:
- loading a first wafer boat to a loading position on a wafer boat loader using the loading means, which loading step comprises introducing the wafer boat into a conditioning chamber;
- transporting the first wafer boat from the loading position into a processing tube;
- carrying out at least one processing step in the processing tube;
- transporting the first wafer boat out of the processing tube;
- removing heat from the conditioning chamber out of the load station; and
- unloading the first wafer boat out of the conditioning chamber of the loading station, preferably via the loading position.

13. The use as claimed in Claim 12 wherein the first wafer boat is transported out of the processing tube into a transfer position, and is then transferred to a cooling down position in the conditioning chamber, wherein preferably the transfer position and the loading position are physically the same position.

14. Method of manufacturing a semiconductor device, preferably a solar cell, comprising the use of the horizontal furnace system for carrying out at least one process step as claimed in any of the preceding claims 12-13, while a semiconductor substrate of the semiconductor device is present in or on a wafer boat.

15. Wafer boat for holding wafers for use in a horizontal furnace system as claimed in any of the preceding claims 1-10, particularly claims 3-10, comprising two side panels connected by a wafer supporting structure, wherein the side panels each comprise:
- at least one support foot for supporting the wafer boat;
- protruding elements protruding substantially perpendicular to the side panels for engagement with holding means of a load station lift; and
- a holding element for cooperation with holding means present on an arm extending from a rotatable shaft, which holding element is configured such that upon rotation of the rotatable shaft and the arm thereto, the wafer boat moves upwards while being supported by the arms and while rotating relative to said arm under the effect of gravity, which holding element is for instance embodied as an arc-shaped protrusion forming a downward facing receptacle for receiving the holding means in the form of a protrusion.
